# EUROPÄISCHE PATENTSCHRIFT

(11) **EP 3 266 031 B1**
(45) Veröffentlichungstag und Bekanntmachung des Hinweises auf die Patenterteilung: **19.02.2020**
(21) Anmeldenummer: 16706576.2
(22) Anmeldetag: 22.02.2016
(51) Int. Cl.: H01H 9/54, H01H 9/00, H01H 9/10, H01H 9/56, H01H 11/00, H01H 47/00, H01H 47/18

(54) **SCHALTVORRICHTUNG ZUM BETREIBEN MINDESTENS EINER LAST**
SWITCH DEVICE FOR OPERATING AT LEAST ONE LOAD
DISPOSITIF DE COMMUTATION PERMETTANT DE FAIRE FONCTIONNER AU MOINS UNE CHARGE

(30) Priorität: 06.03.2015 EP 15157944
(43) Veröffentlichungstag der Anmeldung: 10.01.2018
(73) Patentinhaber: Wöhner GmbH & Co. KG Elektrotechnische Systeme, 96472 Rödental (DE)
(72) Erfinder: LENKER, Hubert, 96515 Sonneberg (DE); STEINBERGER, Philipp, 96450 Coburg (DE)
(74) Vertreter: Isarpatent
(86) Internationale Anmeldenummer: PCT/EP2016/053688
(87) Internationale Veröffentlichungsnummer: WO 2016/142163

(56) Entgegenhaltungen:
- WO-A1-2007/014725
- DE-A1- 3 151 839
- DE-A1- 3 317 964

## Beschreibung

Die Erfindung betrifft eine Schaltvorrichtung zum Betreiben von Lasten, die an ein Schienensystem angeschlossen sind, und insbesondere zum Schalten von Lasten, welche häufig pro Tag geschaltet werden.

Ein Schienensystem, beispielsweise ein Stromsammelschienensystem, weist mehrere, meist parallel angeordnete Stromschienen auf, die unterschiedliche Stromphasen (L) führen. In vielen Anwendungen ist es notwendig, Lasten, insbesondere ohmsche Lasten, häufig, beispielsweise bis zu 20.000 Mal am Tag, ein- oder auszuschalten. Hierzu werden herkömmlicherweise häufig Solid-State Relays mit einer elektrischen Vorsicherung zum Schalten der Lasten an das Stromsammelschienensystem eingesetzt. Diese herkömmlichen Solid-State Relays sind dabei einzeln auf einem Schienenadapter verdrahtet.

Diese herkömmliche Schaltanordnung hat verschiedene Nachteile. Durch die Einzelverdrahtung der Solid-State Relays ist die Montage relativ aufwändig und benötigt relativ viel Montageplatz. Ein weiterer Nachteil ist die durch die eingesetzten Solid-State Relays erfolgte relativ hohe elektrische Verlustleistung.

Aus der DE 31 51 839 A1 ist eine dreiphasige Wechselstromquelle bekannt, welche Ausgangsleitungen aufweist, die über Schütze mit Eingangsleitungen einer induktiven Last schaltbar verbunden sind.

Des Weiteren ist aus der DE 33 17 964 A1 ein Hybridschütz mit einem Hauptschütz und einer parallel dazu angeordneten Thyristoreinrichtung bekannt.

Es ist daher eine Aufgabe der vorliegenden Erfindung, eine Schaltvorrichtung zum Betreiben von Lasten zu schaffen, welche einerseits eine einfache Montage erlaubt und andererseits eine zuverlässige Stromversorgung von Lasten bietet.

Diese Aufgabe wird erfindungsgemäß durch eine Schaltvorrichtung mit den in Patentanspruch 1 angegebenen Merkmalen gelöst.

Die Erfindung schafft demnach eine Schaltvorrichtung zum Betreiben von mindestens einer Last mit
mindestens einer Schalteinheit, die eine abgegriffene Stromphase an eine an die Schalteinheit anschließbare Last zu deren Stromversorgung schaltet und eine Messeinheit aufweist, die einen Stromphasenverlauf der mindestens einen Stromphase misst,
einer lokalen Steuereinheit, die nach Erhalt eines Steuerbefehls von einer externen Steuerung einen Halbleiterschalter der Schalteinheit derart ansteuert, dass der Halbleiterschalter bei einem Nulldurchgang der durch die Messeinheit gemessenen Stromphase schaltet, und mit
einer lokalen Überwachungseinheit, die dem durch die Messeinheit gemessenen Stromphasenverlauf der mindestens einen Stromphase zur Erkennung einer Betriebsabweichung von einer normalen Stromversorgung der jeweiligen an die Schalteinheit angeschlossenen Last auswertet und eine erkannte Betriebsabweichung meldet.

Bei einer möglichen Ausführungsform weist die Schaltvorrichtung mindestens eine Stromphasenüberwachungseinheit auf, welche den zeitlichen Verlauf mindestens einer abgegriffenen Stromphase des Stromsammelschienensystems überwacht.

Bei einer möglichen Ausführungsform der erfindungsgemäßen Schaltvorrichtung erkennt die Stromphasenüberwachungseinheit der Schaltvorrichtung einen Nulldurchgang der zugehörigen abgegriffenen Stromphase und meldet diesen an die lokale Steuerung der Schaltvorrichtung.

Bei einer weiteren möglichen Ausführungsform der erfindungsgemäßen Schaltvorrichtung weist die Schaltvorrichtung mindestens eine Fehlererkennungseinheit bzw. Überwachungseinheit auf, welche überwacht, ob das Schalten der abgegriffenen Stromphase durch die Schalteinheit der Schaltvorrichtung entsprechend dem von der lokalen Steuerung erhaltenen Steuerbefehl erfolgt ist.

Bei einer weiteren möglichen Ausführungsform der erfindungsgemäßen Schaltvorrichtung erkennt die lokale Überwachungseinheit einen aufgetretenen Schaltfehler und meldet diesen an die lokale Steuerung der Schaltvorrichtung.

Bei einer weiteren möglichen Ausführungsform der erfindungsgemäßen Schaltvorrichtung leitet die lokale Steuerung der Schaltvorrichtung einen ihr gemeldeten Schaltfehler über eine Steuerschnittstelle an die externe Steuerung weiter.

Bei einer weiteren möglichen Ausführungsform der erfindungsgemäßen Schaltvorrichtung ist die abgegriffene Stromphase der Hybridschaltung über eine Sicherung, insbesondere eine austauschbare Schmelzsicherung, zugeleitet.

Bei einer weiteren möglichen Ausführungsform der erfindungsgemäßen Schaltvorrichtung erkennt die Fehlererkennungseinheit der Schaltvorrichtung bei Auftreten eines Schaltfehlers die Art des aufgetretenen Schaltfehlers.

Bei einer möglichen Ausführungsform der erfindungsgemäßen Schaltvorrichtung erkennt die Überwachungseinheit, ob der aufgetretene Schaltfehler einen Ausfall einer abgegriffenen Stromphase oder einen von der Schalteinheit abgegebenen Dauerstrom zur Ursache hat.

Bei einer weiteren möglichen Ausführungsform der erfindungsgemäßen Schaltvorrichtung meldet die Überwachungseinheit die Art des aufgetretenen Schaltfehlers an die lokale Steuerung der Schaltvorrichtung.

Bei einer weiteren möglichen Ausführungsform der erfindungsgemäßen Schaltvorrichtung leitet die lokale Steuerung der Schaltvorrichtung die ihr gemeldete Art des aufgetretenen Schaltfehlers über eine Steuerschnittstelle an die externe Steuerung weiter.

Bei einer weiteren möglichen Ausführungsform der erfindungsgemäßen Schaltvorrichtung wertet die externe Steuerung die ihr von der lokalen Steuerung der Schaltvorrichtung gemeldeten Schaltfehler und/oder deren Art aus und steuert die an die Schaltvorrichtung angeschlossenen Lasten entsprechend dem Auswertungsergebnis an.

Bei einer weiteren möglichen Ausführungsform der erfindungsgemäßen Schaltvorrichtung weist die Schaltvorrichtung mindestens einen Temperatursensor auf, welcher eine interne Temperatur, insbesondere eine Temperatur der mindestens einen Schalteinheit, überwacht und diese Temperatur der lokalen Steuerung der Schaltvorrichtung meldet.

Bei einer weiteren möglichen Ausführungsform der erfindungsgemäßen Schaltvorrichtung ist die Steuerschnittstelle der Schaltvorrichtung über einen Optokoppler an die externe Steuerung angeschlossen.

Bei einer weiteren möglichen Ausführungsform der erfindungsgemäßen Schaltvorrichtung weist der mechanische Schalter der als Hybridschaltung ausgebildeten Schalteinheit ein Relais auf.

Bei einer weiteren möglichen Ausführungsform der erfindungsgemäßen Schaltvorrichtung weist der Halbleiterschalter der als Hybridschaltung ausgebildeten Schalteinheit ein Triac auf.

Bei einer weiteren möglichen Ausführungsform der erfindungsgemäßen Schaltvorrichtung weist die Schaltvorrichtung drei Schalteinheiten für drei abgegriffene Stromphasen auf, die als Hybridschaltungen ausgebildet sind und jeweils ein mechanisches Relais und einen dazu parallel verschalteten Triac aufweisen.

Bei einer weiteren möglichen Ausführungsform der erfindungsgemäßen Schaltvorrichtung ist die gesamte Schaltvorrichtung in einem Gerätegehäuse integriert.

Bei einer alternativen Ausführungsform der erfindungsgemäßen Schaltvorrichtung sind jeweils eine Schalteinheit und eine zugehörige lokale Steuerung in einem Gerätegehäuse integriert.

Bei einer weiteren möglichen Ausführungsform der erfindungsgemäßen Schaltvorrichtung weist das Gerätegehäuse der Schaltvorrichtung für jede Stromphase eine Schienenkontaktierung auf.

Bei einer weiteren möglichen Ausführungsform der erfindungsgemäßen Schaltvorrichtung ist die externe Steuerung über eine Steckverbindung an die mindestens eine lokale Steuerung der Schaltvorrichtung anschließbar.

Bei einer weiteren möglichen Ausführungsform der erfindungsgemäßen Schaltvorrichtung ist die mindestens eine Last über eine Steckverbindung an eine Schalteinheit der Schaltvorrichtung anschließbar.

Bei einer weiteren möglichen Ausführungsform der erfindungsgemäßen Schaltvorrichtung wird die Schaltvorrichtung zu einem Stromverteilnetz synchronisiert betrieben.

Bei einer möglichen Ausführungsform weist die Schaltvorrichtung eine Wendestufe auf.

Bei einer möglichen Ausführungsform ist die Schaltvorrichtung auf eine Hutschiene oder eine Montageplatte montierbar.

Die Erfindung schafft ferner ein Schienensystem mit den in Patentanspruch 21 angegebenen Merkmalen.

Die Erfindung schafft demnach ein Schienensystem mit mehreren Schienen für Stromphasen und mit mindestens einer Schaltvorrichtung zum Betreiben von mindestens einer Last mit mindestens einer Schalteinheit, die eine abgegriffene Stromphase an eine an die Schalteinheit anschließbare Last zur deren Stromversorgung schaltet und eine Messeinheit aufweist, die einen Stromphasenverlauf der mindestens einen Stromphase misst,
einer lokalen Steuereinheit, die nach Erhalt eines Steuerbefehls von einer externen Steuerung einen Halbleiterschalter der Schalteinheit derart ansteuert, dass der Halbleiterschalter bei einem Nulldurchgang der durch die Messeinheit gemessenen Stromphase schaltet und mit
einer lokalen Überwachungseinheit, die den durch die Messeinheit gemessenen Stromphasenverlauf der mindestens einen Stromphase zur Erkennung einer Betriebsabweichung von einer normalen Stromversorgung der jeweiligen an die Schalteinheit angeschlossenen Last auswertet und eine erkannte Betriebsabweichung meldet.

Im Weiteren werden mögliche Ausführungsformen der erfindungsgemäßen Schaltvorrichtung zum Betreiben von Lasten unter Bezugnahme auf die beigefügten Figuren näher erläutert.

Es zeigen:
- Fig.1A,1B,1C: Blockschaltbilder zur Darstellung von möglichen Ausführungsbeispielen einer erfindungsgemäßen Schaltvorrichtung zum Schalten von Lasten an ein Schienensystem;
- Fig. 2: ein Signaldiagramm zur Erläuterung der Funktionsweise der erfindungsgemäßen Schaltvorrichtung bei einem Einschaltvorgang;
- Fig. 3: ein Signaldiagramm zur Erläuterung der Funktionsweise des Ausführungsbeispiels der erfindungsgemäßen Schaltvorrichtung bei einem Ausschaltvorgang;
- Fig. 4: eine perspektivische Darstellung eines Stromsammelschienensystems, bei dem mehrere Schaltvorrichtungen zum Schalten von Lasten vorgesehen sind;
- Fig. 5: eine perspektivische Ansicht auf eine Ausführungsform der erfindungsgemäßen Schaltvorrichtung;
- Fig. 6A, 6B: Schaltungsdiagramme von Ausführungsvarianten einer in der Schaltvorrichtung enthaltenen Schalteinheit.

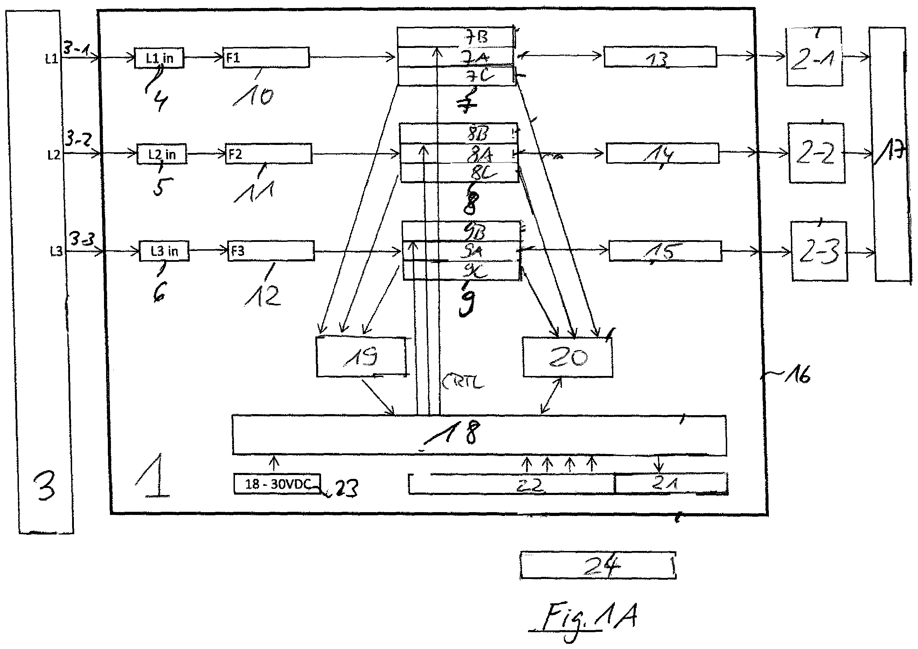

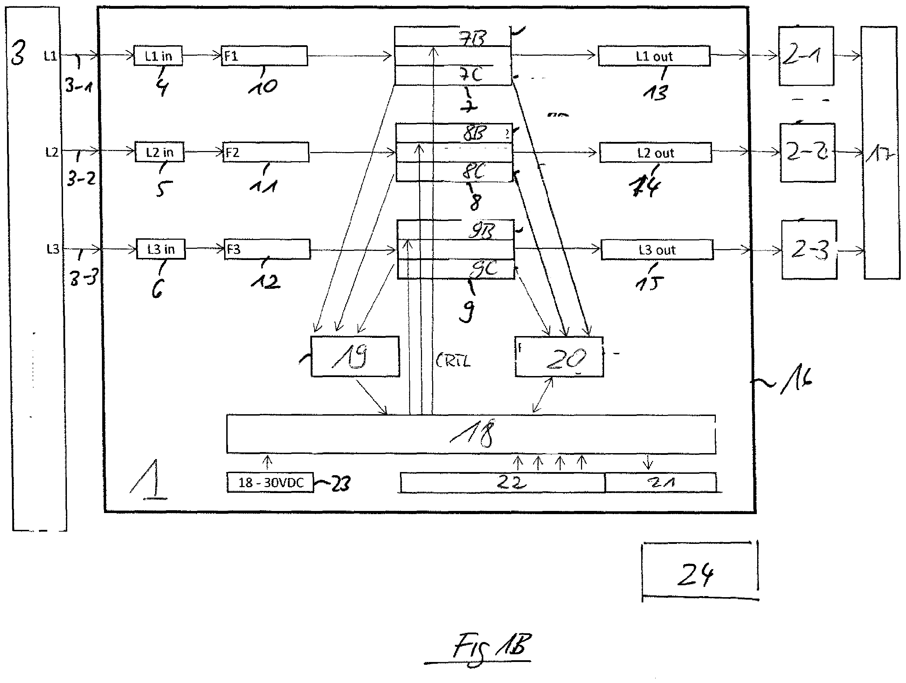

Die Figuren 1A, 1B zeigen zwei mögliche Ausführungsformen einer erfindungsgemäßen Schaltvorrichtung 1. Die Schaltvorrichtung 1 weist bei beiden Ausführungsbeispielen für jede Schaltphase L eine zugehörige Schalteinheit 7, 8, 9 auf. Diese sind eingangsseitig über Schmelzsicherungen 10, 11, 12 mit elektrischen Phasen-Anschlusskontakten 4, 5, 6 verbunden. Bei der in Fig. 1A dargestellten ersten Ausführungsform wird jede der Schalteinheiten 7, 8, 9 durch eine Hybridschaltanordnung gebildet. Dabei weist die Hybridschaltanordnung jeweils einen mechanischen Schalter 7A, 8A, 9A und einen dazu parallel verschalteten Halbleiterschalter 7B, 8B, 9B auf. Bei der in Fig. 1B dargestellten zweiten Ausführungsform besitzt jede Schalteinheit 7, 8, 9 jeweils einen Halbleiterschalter 7B, 8B, 9B. Die Schalteinheiten 7, 8, 9 weisen bei beiden Ausführungsformen, wie sie in den Figuren 1A, 1B dargestellt sind, jeweils eine Messeinheit 7C, 8C, 9C auf. Die Schalteinheiten 7, 8, 9 der Schaltvorrichtung 1 schalten eine abgegriffene Stromphase L an eine an die jeweilige Schalteinheit 7, 8, 9 anschließbare Last 2-1, 2-2, 2-3, wie in den Figuren 1A, 1B dargestellt. Darüber hinaus verfügt jede Schalteinheit 7, 8, 9 über eine Messeinheit 7C, 8C, 9C, die einen Stromphasenverlauf L(t) für mindestens eine Stromphase L misst. Die Messeinheiten 7C, 8C, 9C können dabei bei einer möglichen Ausführungsform jeweils durch einen GMR-Sensor gebildet werden. Alternativ weisen die Messeinheiten 7C, 8C, 9C jeweils Rogowski-Spulen, Stromwandler, Hallsensoren oder Shuntmesswiderstände auf. Die Schaltvorrichtung 1 weist eine lokale Steuereinheit 18 auf, die nach Erhalt eines Steuerbefehls von einer externen Steuerung 24 einen Halbleiterschalter 7B, 8B, 9B der Schalteinheit 7, 8, 9 derart ansteuert, dass der Halbleiterschalter bei einem Nulldurchgang oder zeitlich nahe bei einem Nulldurchgang der durch die jeweilige Messeinheit 7C, 8C, 9C gemessenen Stromphase L(t) schaltet (L(t) = 0). Die Schaltvorrichtung 1 weist eine lokale Überwachungseinheit 20 auf, wie in den Figuren 1A, 1B dargestellt. Die lokale Überwachungseinheit 20 wertet den durch die Messeinheit 7C, 8C, 9C gemessenen Stromphasenverlauf L(t) der mindestens einen Stromphase L zur Erkennung einer Betriebsabweichung von einer normalen Stromversorgung der jeweiligen an die Schalteinheit 7, 8, 9 angeschlossenen Last 2-1, 2-2, 2-3 aus. Die lokale Überwachungseinheit 20 meldet vorzugsweise eine von ihr erkannte Betriebsabweichung an die lokale Steuereinheit 18 und/oder an die externe Steuerung 24. Die normale Stromversorgung einer an die Schalteinheit 7, 8, 9 angeschlossenen Last 2-i ist in der Regel eine sinusförmige Stromphase mit einer vorgegebenen Netzfrequenz f von beispielsweise 50 oder 60 Hz mit einer vorgegebenen bzw. vorbestimmten Stromamplitude. Wird von dieser normalen Stromversorgung abgewichen, erkennt dies die lokale Überwachungseinheit 20 und meldet dies vorzugsweise an die lokale Steuereinheit 18, die in der Schaltvorrichtung 1 integriert ist, und/oder an eine externe Steuerung 24 über eine Schnittstelle der Schaltvorrichtung 1.

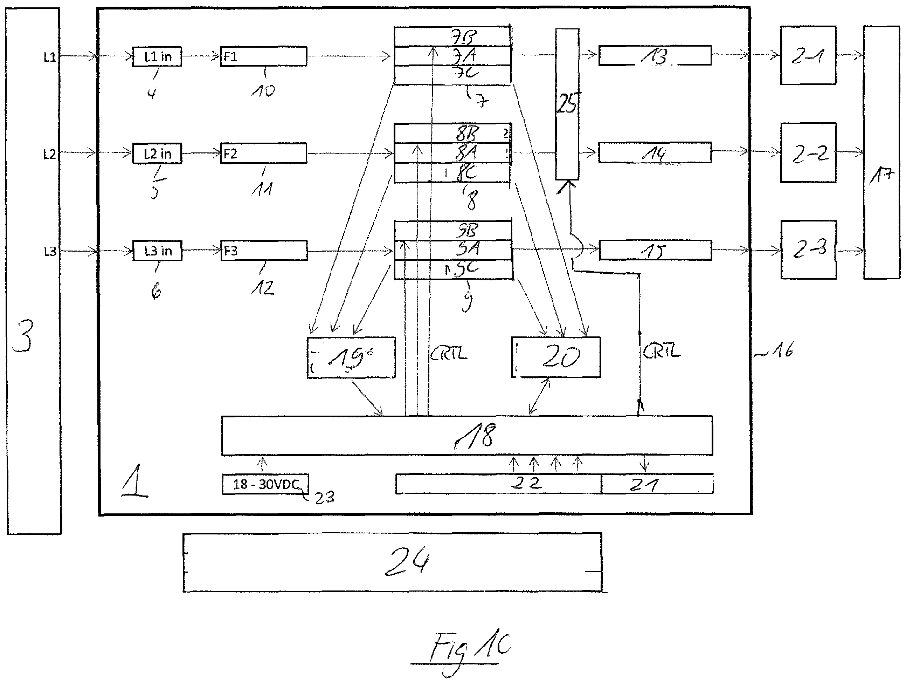

Fig. 1A zeigt schematisch als Blockschaltbild ein exemplarisches Ausführungsbeispiel einer erfindungsgemäßen Schaltvorrichtung 1 zum Schalten von mindestens einer Last 2 an eine Stromphase L eines Schienensystems 3 oder eines Hutschienenadapters. Das Schienensystem 3 umfasst bei dem in Fig. 1 dargestellten Ausführungsbeispiel drei Stromphasen L1, L2, L3. Das Schienensystem 3 ist bei einer möglichen Ausführungsform ein Stromsammelschienensystem mit mehreren Stromsammelschienen. Das Schienensystem 3 kann auch eine Hutschiene zur mechanischen Befestigung und weitere elektrische Schienen oder Leitungen für die Stromphasen L1, L2, L3 aufweisen. Die Schaltvorrichtung 1 kann auch in einem Sammelschienenadapter enthalten sein. Für jede Stromphase L1, L2, L3 ist eine Schiene, d.h. eine Stromsammelschiene oder eine sonstige Schiene, vorgesehen. Für jede Stromphase L1, L2, L3 ist eine zugehörige Schienenkontaktierung 4, 5, 6 vorgesehen, wie in Fig. 1A dargestellt. Die Schaltvorrichtung 1 weist bei dem dargestellten Ausführungsbeispiel für jede abgegriffene Stromphase L eine Schalteinheit 7, 8, 9 auf. Vorzugsweise wird zwischen die Schienenkontaktierung 4, 5, 6 und der jeweiligen Schalteinheit 7, 8, 9 ein Sicherungselement vorgesehen, vorzugsweise eine austauschbare Schmelzsicherung 10, 11, 12, wie in Fig. 1A gezeigt. Diese weisen beispielsweise einen Stromschwellenwert von 20 Ampere auf. Ausgangsseitig ist jede Schalteinheit 7, 8, 9 mit einem Phasenausgangsanschluss 13, 14, 15 verbunden, an dem jeweils eine Last 2-1, 2-2, 2-3 anschließbar ist. Vorzugsweise sind die Lasten 2-1, 2-2, 2-3 über eine Steckverbindung an die in einem Gehäuse 16 integrierte Schaltvorrichtung 1 anschließbar. Ausgangsseitig sind die Lasten 2-1, 2-2, 2-3 vorzugsweise an einen Neutralleiter 17 angeschlossen. Die Lasten 2-i sind bei einer möglichen Ausführungsform ohmsche Lasten. Alternativ können die Lasten 2-i auch kapazitive und/oder induktive Lasten umfassen. Die Lasten 2-i sind beispielsweise Beleuchtungseinheiten, Heizungseinheiten oder Motoreinheiten.

Die verschiedenen Schalteinheiten 7, 8, 9 sind jeweils dazu ausgelegt, eine von einer stromführenden Schiene des Schienensystems 3 abgegriffene Stromphase L1, L2, L3 an eine an die Schalteinheit 7, 8, 9 anschließbare Last 2-1, 2-2, 2-3 zu schalten. Bei einer möglichen Ausführungsform werden die Schalteinheiten 7, 8, 9 jeweils durch eine Hybridschaltung gebildet. Jede Hybridschaltung 7, 8, 9 weist einen mechanischen Schalter 7A, 8A, 9A und einen dazu parallel verschalteten Halbleiterschalter 7B, 8B, 9B auf. Bei einer möglichen Ausführungsform handelt es sich bei dem mechanischen Schalter 7A, 8A, 9A jeweils um ein Relais bzw. Schaltrelais. Der dazu parallel verschaltete Halbleiterschalter 7B, 8B, 9B ist vorzugsweise ein Triac. Bei dem in Fig. 1A dargestellten Ausführungsbeispiel sind die verschiedenen Schalteinheiten 7, 8, 9 in einem Gehäuse 16 der Schaltvorrichtung 1 integriert bzw. enthalten. Alternativ können die verschiedenen Schalteinheiten 7, 8, 9 auch in unterschiedlichen Gehäusen integriert werden.

Die Schaltvorrichtung 1 weist eine lokale Steuerung 18 auf, welche mechanische Schalter und/oder Halbleiterschalter der verschiedenen Schalteinheiten 7, 8, 9 nach Erhalt eines Steuerbefehls von einer externen Steuerung derart ansteuert, dass sie jeweils während eines Nulldurchganges der abgegriffenen Stromphase L bzw. möglichst zeitnah zu einem Nulldurchgang schalten. Bei dem in Fig. 1A dargestellten Ausführungsbeispiel hat die Schaltvorrichtung 1 als Schalteinheiten 7, 8, 9 Hybridschaltungen, die jeweils eine Strommesseinheit 7C, 8C, 9C aufweisen, welche den zeitlichen Verlauf der jeweiligen abgegriffenen Stromphase L überwacht. Die Strommesseinheit 7C, 8C, 9C einer Schalteinheit 7, 8, 9 erkennt jeweils einen Nulldurchgang der jeweiligen abgegriffenen Stromphase L1, L2, L3 und meldet diesen Nulldurchgang an die lokale Steuerung 18 der Schaltvorrichtung 1. Alternativ kann eine Messeinrichtung vorgesehen sein, welche mit einer integrierten Stromüberwachungseinheit 19 verbunden sind, wobei die Messeinrichtung alle Stromphasen L überwacht und erkannte Nulldurchgänge an die lokale Steuerung 18 der Schaltvorrichtung 1 meldet.

Bei einer möglichen Ausführungsform weist die Schaltvorrichtung 1 ferner mindestens eine lokale Überwachungseinheit bzw. Fehlererkennungseinheit 20 auf, welche überwacht, ob das Schalten der abgegriffenen Stromphase L durch die jeweilige Schalteinheit 7, 8, 9 entsprechend dem von der lokalen Steuerung 18 von einer externen Steuerung 24 erhaltenen Steuerbefehl tatsächlich und fehlerfrei erfolgt ist. Hierdurch wird die Kontrolle gewährleistet, dass die erteilten Steuerbefehle tatsächlich durch die Schaltvorrichtung 1 umgesetzt worden sind. Die lokale Überwachungseinheit 20 wertet den durch die mindestens eine Messeinheit 7C, 8C, 9C gemessenen Stromphasenverlauf L(t) der entsprechenden Stromphase L zur Erkennung einer Betriebsabweichung von einer normalen Stromversorgung der jeweiligen an die Schalteinheit 7, 8, 9 angeschlossenen Last 2 aus. Die lokale Überwachungseinheit 20 kann eine erkannte Betriebsabweichung von der normalen Stromversorgung an die lokale Steuerung 18 und/oder die externe Steuerung 24 melden. Die Stromüberwachungseinheit 19 und/oder die lokale Überwachungseinheit 20 bzw. Fehlererkennungseinheit 20 können in der lokalen Steuerung 18 integriert sein. Durch die lokale Steuerung 18 erfolgt vorzugsweise eine laufende Kontrolle, ob Schaltaufgaben durch die Schalteinheiten 7, 8, 9 entsprechend den von der externen Steuerung 24 erhaltenen Schaltbefehlen richtig bzw. fehlerfrei umgesetzt werden. Es wird durch die lokale Überwachungseinheit 20 erkannt, ob ein Phasenausfall einer Stromphase L vor oder nach dem Gerät bzw. der Schaltvorrichtung 1 auftritt. Es kann ferner erkannt werden, ob ein durchlegierter Halbleiter 7B, 8B, 9B oder ein verklebter mechanischer Kontakt 7A, 8A, 9A vorliegt. Bei einer möglichen Ausführungsform erkennt die Überwachungseinheit 20 einen aufgetretenen Schaltfehler und meldet diesen an die lokale Steuerung 18 der Schaltvorrichtung 1. Bei einer möglichen Ausführungsform leitet die lokale Steuerung 18 den gemeldeten Schaltfehler über eine Steuerschnittstelle 21 Fehlermeldungen an die externe Steuerung 24 weiter. Bei einer weiteren möglichen Ausführungsform erhält die lokale Steuerung 18 Steuerbefehle über Steuereingänge 22 bzw. eine weitere Steuerschnittstelle von der externen Steuerung 24. Bei einer möglichen Ausführungsform ist die externe Steuerung 24 direkt oder über einen Steuerbus über eine Steckverbindung an die Schaltvorrichtung 1 angeschlossen bzw. gesteckt. Bei einer möglichen Ausführungsform verfügt die Schaltvorrichtung 1 zusätzlich über eine integrierte Stromversorgung 23 zur Stromversorgung der darin integrierten elektronischen Schaltkomponenten, insbesondere der integrierten lokalen Steuerung 18.

Bei einer möglichen Ausführungsform erkennt die Überwachungseinheit 20 bei Auftreten eines Schaltfehlers die Art des aufgetretenen Schaltfehlers. Die Überwachungseinheit 20 erkennt einen möglichen Stromausfall, beispielsweise durch Phasenausfall oder durch eine ausgelöste Schmelzsicherung, sowie einen unbeabsichtigten Dauerstrom, beispielsweise wenn ein Halbleiterschalter 7B, 8B, 9B durchlegiert oder ein mechanisches Relais 7A, 8A, 9A verschweißt ist. Diese Fehlerart bzw. Fehlerursache wird vorzugsweise von der Überwachungseinheit 20 an die interne Steuerung 18 der Schaltvorrichtung 1 gemeldet. Bei einer möglichen Ausführungsform generiert die interne bzw. lokale Steuerung 18 der Schaltvorrichtung 1 eine entsprechende Fehlermeldung und gibt diese Fehlermeldung über die Steuerschnittstelle 21 an die externe Steuerung 24 ab. Die externe Steuerung 24 ist direkt oder indirekt an die Steuerschnittstelle 21 angeschlossen. Die externe Steuerung 24 kann beispielsweise eine speicherprogrammierte Steuerung, SPS, einer Maschine bzw. eines Gerätes sein. Bei einer möglichen Ausführungsform ist die Steuerschnittstelle 21 der Schaltvorrichtung 1 über einen Optokoppler an die externe Steuerung 24 angeschlossen. Die externe Steuerung 24 gibt einerseits Steuerbefehle über die Steuerschnittstelle 21 an die interne Steuerung 18 und erhält umgekehrt von der lokalen Steuerung 18 Fehlermeldungen. Bei einer möglichen Ausführungsform wertet die externe Steuerung 24 die von der lokalen Steuerung 18 der Schaltvorrichtung 1 gemeldeten Schaltbefehle aus und steuert die an der Schaltvorrichtung 1 angeschlossenen Lasten 2-i entsprechend dem Auswertungsergebnis an. Bei der Auswertung werden bei einer möglichen Ausführungsform durch die externe Steuerung 24 auch Informationen über die an der Schaltvorrichtung 1 angeschlossenen Lasten 2-i mitberücksichtigt. Bei Auftreten eines Schaltfehlers entscheidet die externe Steuerung 24 vorzugsweise anhand der vermutlichen Fehlerursache bzw. der Art des gemeldeten Schaltfehlers sowie auf Basis der an die Schaltvorrichtung 1 angeschlossenen Lasten 2-i, ob es sich bei dem aufgetretenen Schaltfehler um einen kritischen Schaltfehler oder einen unkritischen Schaltfehler handelt. Bei einer möglichen Ausführungsform wird bei Auftreten eines kritischen Schaltfehlers die entsprechende Last 2-i ab- bzw. ausgeschaltet. Handelt es sich umgekehrt um einen unkritischen Schaltfehler, kann die entsprechende Last 2-i bei einer möglichen Ausführungsform zunächst weiterbetrieben werden. Bei einer möglichen Ausführungsform verfügt die erfindungsgemäße Schaltvorrichtung 1 über eine mit der internen Steuerung 18 verbundene Anzeigeeinrichtung bzw. eine LED-Anzeige oder dergleichen. Bei Auftreten eines Schaltfehlers, insbesondere eines kritischen Schaltfehlers, wird das Auftreten des Schaltfehlers über die Anzeigeeinrichtung einem Nutzer angezeigt. Bei Auftreten eines kritischen Schaltfehlers wird die entsprechende Last 2-i vorzugsweise so schnell wie möglich direkt oder indirekt aus- bzw. abgeschaltet und kann anschließend ausgetauscht werden.

Fig. 1B zeigt eine weitere mögliche Ausführungsform der erfindungsgemäßen Schaltvorrichtung 1. Bei der in Fig. 1B dargestellten Ausführungsform weist jede Schalteinheit 7, 8, 9 einen Halbleiterschalter 7B, 8B, 9B und eine Messeinheit 7C, 8C, 9C auf. Die Halbleiterschalter 7B, 8B, 9B werden jeweils durch die lokale Steuerung 18 der Schaltvorrichtung 1 angesteuert. Die Messeinheiten 7C, 8C, 9C liefern Messsignale an die Stromüberwachungseinheit 19 und die lokale Überwachungseinheit 20 wie in Fig. 1B gezeigt. Die Halbleiterschalter 7B, 8B, 9B sind jeweils zwischen Schmelzsicherungen 10, 11, 12 und Phasenausgangsanschlüssen 13, 14, 15 der Schaltvorrichtung 1 verschaltet. Die übrigen Einheiten bzw. Komponenten entsprechen den Einheiten bzw. Komponenten der in Fig. 1A gezeigten Ausführungsform.

Die angeschlossenen Lasten 2-i, wie sie in Fig. 1A, 1B, 1C dargestellt sind, können unterschiedliche Lasten 2-i umfassen, beispielsweise Motoreinrichtungen, Ventilationseinrichtungen oder Beleuchtungseinrichtungen. Bei einer möglichen Ausführungsform handelt es sich bei den Lasten 2-i um Werkzeugeinheiten, beispielsweise Heizeinrichtungen des Herstellungsgerätes, beispielsweise innerhalb der Lebensmittelindustrie oder bei der Kunststoffverarbeitung. Bei einer weiteren möglichen Ausführungsform der erfindungsgemäßen Schaltvorrichtung 1 weist diese ein oder mehrere Temperatursensoren auf, welche innerhalb des Gehäuses 16 angebracht sein können. Diese Temperatursensoren messen bei einer möglichen Ausführungsform die Innentemperatur, insbesondere die Temperatur T der verschiedenen Schalteinheiten 7, 8, 9. Die gemessenen Temperaturen T werden bei einer möglichen Ausführungsform der internen Steuerung 18 signalisiert. Bei den in Fig. 1A, 1B, 1C dargestellten Ausführungsbeispielen sind die drei Schalteinheiten 7, 8, 9 sowie die zugehörigen Sicherungen 10, 11, 12 und die interne Steuerung 18 in einem Gehäuse 16 integriert. Bei einer alternativen Ausführungsform können die Schalteinheiten 7, 8, 9 sowie ihre zugehörigen Sicherungen 10, 11, 12 jeweils in einem separaten Gerätegehäuse integriert sein und über eine eigene interne Steuerung verfügen.

Die Schaltvorrichtung 1 ist vorzugsweise mit einem Stromnetz, das eine vorgegebene Netzfrequenz von 45Hz bis 65 Hz aufweist, synchronisiert. Die zu einem beliebigen Zeitpunkt erteilten bzw. erhaltenen Schaltbefehle werden vorzugsweise für eine kurze Zeit verzögert, damit in einem möglichst günstigen Zeitpunkt nahe dem Nulldurchgang der abgegriffenen Stromphase ein Schaltvorgang erfolgt. Die Zeitverzögerung des mechanischen Schalters 7A, 8A, 9A, insbesondere Relais, wird vorzugsweise beim Ein- und Ausschalten der Ablaufsteuerung mitberücksichtigt. Der zu dem mechanischen Schalter bzw. Relais 7A, 8A, 9A vorzugsweise parallel verschaltete Triac 7B, 8B, 9B der Schalteinheit 7, 8, 9 sorgt dafür, dass Exemplarstreuungen verschiedener Relais ausgeglichen werden können und das entsprechende Relais immer lastfrei schaltet. Die Dauer und die Höhe des Stromflusses I in dem Halbleiterschalter bzw. Triac 7B, 8B, 9B werden vorzugsweise zu einem optimal eingestellten Schaltzeitpunkt möglichst geringgehalten. Die Verlustleistungen des Triacs 7B, 8B, 9B entstehen nur für eine kurze Zeitdauer bei geringem elektrischen Strom.

Die Schalteinheiten 7, 8, 9 werden bei einer bevorzugten Ausführungsform durch Hybridschaltungen gebildet, die jeweils einen mechanischen Schalter und einen dazu parallel verschalteten Halbleiterschalter aufweisen. Bei den Hybridschaltungen 7, 8, 9 übernehmen jeweils die Halbleiterschalter bzw. Triac 7B, 8B, 9B die Schaltarbeit und die mechanischen Schalter bzw. Relais 7A, 8A, 9A die Bereitstellung eines Dauerstroms. Bei einem Einschaltvorgang wird zum optimalen Zeitpunkt der mechanische Schalter bzw. das Relais 7A, 8A, 9A der Hybridschaltung bzw. Schalteinheit 7, 8, 9 angesteuert, wobei der mechanische Schalter 7A, 8A, 9A eine gewisse Schaltverzögerung besitzt. Bevor der Relaiskontakt schließt, wird der Halbleiterschalter bzw. das Triac 7B, 8B, 9B durchgeschaltet. Nachdem der Relaiskontakt 7A, 8A, 9A geschlossen ist, wird der Halbleiterschalter bzw. das Triac 7B, 8B, 9B abgeschaltet. Damit ist der Einschaltvorgang der Hybridschaltung, die durch die interne Steuerung 18 angesteuert wird, für die jeweilige Last 2 abgeschlossen.

Bei einer möglichen Ausführungsform weist die Schaltvorrichtung 1 eine Wendestufe 25 auf, wie in Fig. 1C dargestellt. Die Wendestufe 25 kann sich, wie in Fig. 1C gezeigt, über zwei Phasen L1, L2 erstrecken, oder alternativ über drei Phasen L1, L2, L3. Mit Hilfe der Wendestufe 25 kann beispielsweise die Drehrichtung bei einem Motor als Last umgekehrt werden. Die Wendestufe 25 wird vorzugsweise durch die interne Steuerung 18 angesteuert.

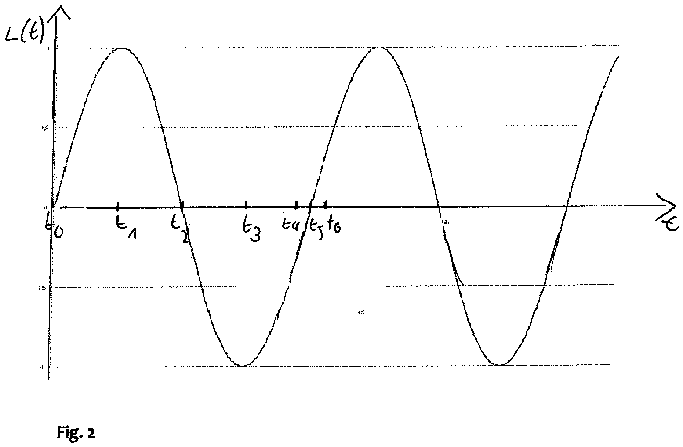

Fig. 2 zeigt schematisch einen Einschaltvorgang bei einer Schalteinheit 7, 8, 9, die durch eine Hybridschaltung gebildet wird, innerhalb der Schaltvorrichtung 1 anhand eines Signaldiagramms der betroffenen Stromphase L. Die abgegriffene Stromphase L hat einen sinusförmigen Zeitverlauf und weist eine vorgegebene Frequenz f von beispielsweise 50 Hz auf. Zu einem Zeitpunkt t1 erhält die lokale Steuerung 18 der Schaltvorrichtung 1 einen externen Einschaltbefehl durch die externe Steuerung 24. Bei dem in Fig. 2 dargestellten Beispiel ist zum Zeitpunkt t1, zu dem die lokale Steuerung 18 den Schaltbefehl erhält, die verbleibende Zeit bis zum nächsten Nulldurchgang zum Zeitpunkt t2 zu gering, da zu viel Verlustleistung in dem Halbleiterschalter 7B, 8B, 9B der Hybridschaltung 7, 8, 9 entstehen würde. Unter Berücksichtigung der vorgegebenen Einschaltverzögerung des mechanischen Schalters bzw. des Relais 7A, 8A, 9A erhält in der nächsten Halbwelle der abgegriffenen Stromphase L das Relais 7A, 8A, 9A von der lokalen Steuerung 18 zum Zeitpunkt t3 den Einschaltbefehl. Zum Zeitpunkt t4 erhält die Triac-Schaltung 7B, 8B, 9B der Hybridschaltanordnung 7, 8, 9 noch vor dem nächsten Nulldurchgang den Durchschaltbefehl von der lokalen Steuerung 18. Vom Zeitpunkt t5, in der zeitlichen Nähe des Nulldurchganges der abgegriffenen Stromphase L, bis zum Zeitpunkt t6 sind der Triac-Schalter 7B, 8B, 9B und der entsprechende mechanische Schalter bzw. das Relais 7A, 8A, 9A gleichzeitig aktiv. Ab Zeitpunkt t6 kann das Triac 7B, 8B, 9B abgeschaltet werden. Mithilfe des Triacs 7B, 8B, 9B können die Streuungen bei der Herstellung des mechanischen Schalters bzw. des Relais 7A, 8A, 9A ausgeglichen werden. Wenn ausreichend Zeit zwischen Einschaltbefehl und nächsten Nulldurchgang vorhanden ist, erfolgt der Ablauf so, dass zum nächsten Nulldurchgang eingeschaltet wird.

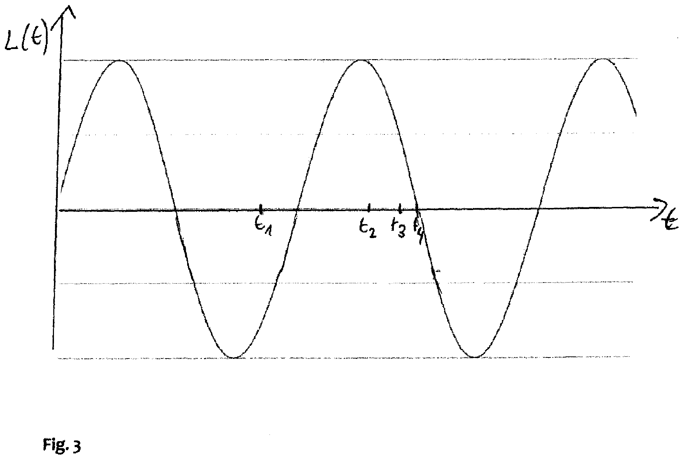

Fig. 3 zeigt schematisch anhand eines Signaldiagramms einer abgegriffenen Stromphase L einen durch eine als Hybridschaltung ausgebildete Schalteinheit 7, 8, 9 der Schaltvorrichtung 1 durchgeführten Ausschaltvorgang. Der mechanische Schalter bzw. das Relais 7A, 8A, 9A der Hybridschaltanordnung 7, 8, 9 befinden sich zunächst in eingeschaltetem Zustand. Zum Zeitpunkt t1 erhält die interne Steuerung 18 der Schaltvorrichtung 1 einen Ausschaltbefehl zum Ausschalten bzw. Sperren der für die Stromphase L vorgesehenen Hybridschaltung von der externen Steuerung. Bei dem gezeigten Beispiel ist die Zeitdauer bis zum nächsten Nulldurchgang der abgegriffenen Phase L zu gering, da viel Verlustleistung in dem Triac 7B, 8B, 9B der Hybridschaltung 7, 8, 9 entstehen würde. Zum Zeitpunkt t2 in der nächsten Halbphase wird der Halbleiterschalter bzw. Triac 7B, 8B, 9B der Hybridschaltung 7, 8, 9 durchgeschaltet und das zugehörige Relais 7A, 8A, 9A unter Berücksichtigung der Relaisausschaltverzögerung ausgeschaltet. Zum Zeitpunkt t3 wird der Triac 7B, 8B, 9B unter Berücksichtigung seiner kurzen Schaltverzögerung wieder ausgeschaltet, sodass zum Zeitpunkt t4 nahe des Nulldurchganges der entsprechenden Phase L der Ausschaltvorgang beendet ist und die Last 2 von der entsprechenden Phase L getrennt ist. Wenn ausreichend Zeit zwischen Ausschaltbefehl und nächsten Nulldurchgang vorhanden ist, erfolgt der Ablauf so, dass zum nächsten Nulldurchgang der Ausschaltvorgang abgeschlossen wird.

Bei einer möglichen Ausführungsform werden verschiedene Fehlerzustände bzw. Fehlertypen durch die Überwachungseinheit bzw. Fehlererkennungseinheit 20 als Störungen erkannt bzw. erfasst. Diese Störungen umfassen beispielsweise ein Auslösen der entsprechenden Vorsicherung 10, 11, 12 oder dass der Triac bzw. Halbleiterschalter 7B, 8B, 9B durchlegiert ist. Dies bedeutet, dass der Halbleiterschalter 7B, 8B, 9B einen Defekt aufweist und andauernd Strom leitet. Weiterhin kann durch die lokale Überwachungseinheit 20 erfasst werden, ob interne Grenztemperaturen überschritten sind. Bei einer möglichen Ausführungsform weist jede Schalteinheit 7, 8, 9 einen Temperatursensor auf, welcher die Temperatur T der jeweiligen Schalteinheit 7, 8, 9 an die lokale Überwachungseinheit 20 meldet. Mögliche Störungen, insbesondere auch Temperaturstörungen, werden vorzugsweise durch die interne Steuerung 18 über die Schnittstelle an die externe Steuerung 24 gemeldet und können nach Abschaltung der Netzspannung optisch signalisiert werden.

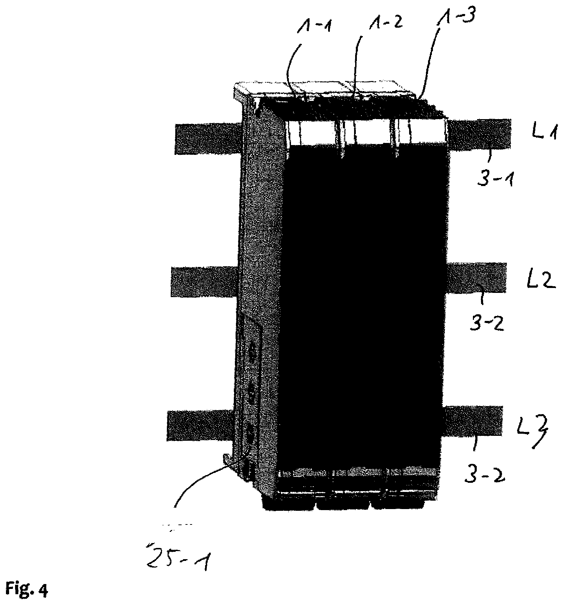

Fig. 4 zeigt schematisch ein Schienensystem 3, das drei Schaltvorrichtungen 1, wie sie in dem Blockschaltbild von Fig. 1 dargestellt sind, aufweist. Das in Fig. 4 dargestellte Schienensystem 3 weist drei Stromsammelschienen 3-1, 3-2, 3-3 auf, die drei Stromphasen L1, L2, L3 führen. Bei dem dargestellten Ausführungsbeispiel weist jede der drei Schaltvorrichtungen 1-1, 1-2, 1-3 drei Hybridschaltungen 7-1, 8-1, 9-1; 7-2, 8-2, 9-2; 7-3, 8-3, 9-3 auf. Insgesamt können an die drei Schaltvorrichtungen 1, wie sie in Fig. 4 dargestellt sind, beispielsweise neun Lasteinrichtungen bzw. Lasten 2-i angeschlossen werden. Das Gerätegehäuse 16-i der Schaltvorrichtung 1 weist für jede Stromphase L eine Schienenkontaktierung auf. In dem Gerätegehäuse kann seitlich eine Klappe zum Austausch der darin enthaltenen Schmelzsicherungen 10, 11, 12 vorgesehen sein. Für die erste Schaltvorrichtung 1-1 erkennt man seitlich in Fig. 4 eine derartige Austauschklappe 25-i zum Austausch der darin enthaltenen drei Schmelzsicherungen 10, 11, 12. Wie man in Fig. 4 erkennen kann, zeichnet sich die Schaltanordnung durch einen geringen Platzbedarf aus. Alle Anschlüsse können über Steckverbinder erfolgen. Als Lasten 2-i können beispielsweise Motoren bzw. Elektromotoren, Heizungselemente oder Belichtungselemente angeschlossen werden. Bei Schalteinheiten 7, 8, 9, die durch Hybridschaltungen gebildet werden, ist die auftretende Verlustleistung P bei dem Schaltvorgang sehr gering und beträgt beispielsweise ca. 30 % weniger als eine vergleichbare Anordnung, welche Solid-State Relays verwendet. Durch die geringe Verlustleistung P und die damit verbundene geringere Erwärmung wird auch die Betriebsdauer der erfindungsgemäßen Schaltvorrichtung 1 gesteigert. Mit der erfindungsgemäßen Schaltvorrichtung 1 ist es möglich, Hauptbetriebs- und Steuerstromkreise zu trennen. Für jede abgegriffene Stromphase L wird ein unabhängiger Stromkreis bereitgestellt, wobei alle Anschlüsse steckbar sind. Die erfindungsgemäße Schaltvorrichtung 1 eignet sich für ein Schienensystem mit Adapter oder Stromschienenadapter. Die erfindungsgemäße Schaltvorrichtung 1 kann für verschiedene stromführende Schienensysteme eingesetzt werden, insbesondere für Stromsammelschienensysteme oder Hutschienensysteme. Die Strommesseinheiten 7C, 8C, 9C weisen bei einer Ausführungsform GMR-Sensoren auf. Alternativ weisen die Messeinheiten 7C, 8C, 9C Rogowski-Spulen, Hallsensoren, Stromwandler oder Shuntmesswiderstände auf.

Die erfindungsgemäße Schaltvorrichtung 1 eignet sich zum Betreiben von mindestens einer Last 2-i, die an eine Schalteinheit 7, 8, 9 der Schaltvorrichtung 1 angeschlossen ist. Die Schaltvorrichtung 1 kann zum Fehler- und Servicemanagement bei einer Anlage mit mehreren Lasten eingesetzt werden und bei einem Ausfall oder bei einer Beeinträchtigung einer Stromversorgung eine Warnmeldung erzeugen, die beispielsweise an eine zentrale Steuerung bzw. externe Steuerung 24 der Anlage übermittelt werden kann.

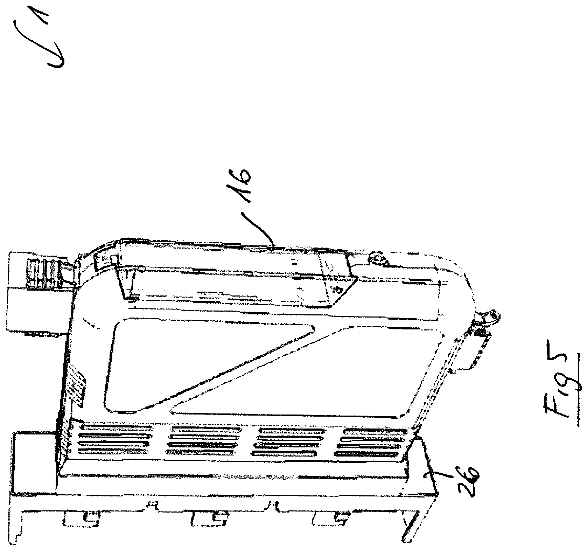

Fig. 5 zeigt eine perspektivische Ansicht auf ein exemplarisches Ausführungsbeispiel einer erfindungsgemäßen Schaltvorrichtung 1 mit einem Gehäuse 16. Das Gehäuse 16 kann bei dem dargestellten Ausführungsbeispiel mittels eines Schienenadapters 26 auf ein Schienensystem montiert werden. Bei dem in Fig. 5 dargestellten Ausführungsbeispiel ist der Schienenadapter 26 ein Stromsammelschienenadapter zum Aufsetzen auf ein Stromsammelschienensystem. Bei einer möglichen Ausführungsform können die in den Figuren 1A, 1B dargestellten Anschlusskontakte 4, 5, 6 mit entsprechenden Kontaktierungen des Schienenadapters 16 verbunden werden, indem beispielsweise aus dem Gehäuse 16 hervorstehende elektrische Kontakte in entsprechende Buchsen des Schienenadapters 26 eingesteckt werden. Bei dieser Ausführungsform kann das Gehäuse 16 in den Schienenadapter 26 eingesteckt werden, der seinerseits auf mehrere Stromsammelschienen 3-1, 3-2, 3-3 des Stromsammelschienensystems 3 montiert wird. Bei einer alternativen Ausführungsform kann der Schienenadapter 26 in der Schaltvorrichtung 1 integriert sein, d.h., der Schienenadapter 26 ist bei dieser alternativen Ausführungsform an das Gehäuse 16 der Schaltvorrichtung 1 angeformt. Fig. 5 zeigt lediglich ein Ausführungsbeispiel einer erfindungsgemäßen Schaltvorrichtung 1. Alternativ kann die Schaltvorrichtung 1 auch für andere stromführende Schienen vorgesehen sein. Weiterhin ist es möglich, dass die Schaltvorrichtung 1 an einer Montageplatte oder ein Crossboard angebracht ist. Weiterhin ist es möglich, dass die Schaltvorrichtung 1 mechanisch auf eine Hutschiene direkt oder mittels eines mechanischen Adapters montiert wird und elektrische Anschlusskabel mit elektrischen Anschlusskontakten 4, 5, 6 zur Zuführung der Stromphasen L1, L2, L3 verbunden werden.

Die erfindungsgemäße Schaltvorrichtung 1 lässt sich für eine präventive Wartung einer Anlage einsetzen. Die lokale Steuerung 18 der Schaltvorrichtung 1 kann beispielsweise einen Phasenausfall einer Stromphase L melden. Weiterhin kann die lokale Steuerung 18 einen Lastfehler bzw. einen Fehler eines an die Schaltvorrichtung 1 angeschlossenen Gerätes über eine Schnittstelle an eine externe Steuerung 24 einer Anlage melden bzw. ein entsprechendes Warnsignal abgeben. Die lokale Steuerung 18 der Schaltvorrichtung 1 kann sowohl Softwarefehler als auch Hardwaredefekte an die externe Steuerung 24 melden. Weiterhin ermittelt die lokale Steuerung 18 vorzugsweise einen Warnhinweis, falls von der externen Steuerung 24 erhaltene Schaltbefehle gar nicht oder nur teilweise bzw. fehlerhaft seitens der Schalteinheiten 7, 8, 9 der Schaltvorrichtung 1 durchgeführt worden sind. Bei einer möglichen Ausführungsform kann die lokale Steuerung 18 eine an die Schaltvorrichtung 1 angeschlossene defekte Last 2-i an die externe Steuerung 24 über eine Schnittstelle melden. Bei einer weiteren möglichen Ausführungsform kann die lokale Steuerung 18 der externen Steuerung auch eine falsch angeschlossene Last 2-i melden. Bei einer möglichen Ausführungsform erkennt die Überwachungseinheit 20 mittels der Messeinheiten 7C, 8C, 9C der Schalteinheiten 7, 8, 9, ob die an die Phasenausgangsanschlüsse 13, 14, 15 der Schaltvorrichtung 1 angeschlossenen Lasten 2-1, 2-2, 2-3 ohmsche, induktive oder kapazitive Lasten sind. Bei einer möglichen Ausführungsform ermittelt die Überwachungseinheit 20 aufgrund der durch die Messeinheiten 7C, 8C, 9C durchgeführten Messungen einen komplexen Widerstand Z der an die Phasenausgangsanschlüsse 13, 14, 15 angeschlossenen Lasten 2-1, 2-2, 2-3 und meldet den ermittelten komplexen Widerstand Z der angeschlossenen Last z-i an die lokale Steuerung 18 der Schaltvorrichtung 1 und/oder über eine Schnittstelle an die externe Steuerung 24 der Anlage. Bei einer möglichen Ausführungsform überwacht die Überwachungseinheit 20 eine Veränderung des Lastverhaltens der angeschlossenen Lasten 2-1, 2-2, 2-3, insbesondere aufgrund von Verschleiß der Lasten während des laufenden Betriebs der Anlage. Beispielsweise kann bei einer möglichen Ausführungsform die zeitliche Veränderung Z(t) des komplexen Widerstandes Z der Lasten 2-1, 2-2, 2-3 von der Überwachungseinheit 20 an die lokale Steuerung 18 und/oder an die externe Steuerung 24 der Anlage übertragen werden. Befindet sich beispielsweise aufgrund der Messungen der berechnete komplexe Widerstand Z der an die Schaltvorrichtung 1 angeschlossenen Lasten z-i außerhalb eines zulässigen Betriebsbereichs, kann dies der externen Steuerung 24 gemeldet werden, sodass dort eine präventive Wartung bzw. ein Austausch der entsprechenden betroffenen Last 2-i veranlasst wird.

Mit der erfindungsgemäßen Schaltvorrichtung 1 erfolgt vorzugsweise eine Trennung in Hauptbetriebs- und Steuerstromkreisen. Die erfindungsgemäße Schaltvorrichtung 1, wie sie in den Figuren 1A, 1B dargestellt ist, erlaubt beispielsweise das Betreiben von drei unabhängigen Stromkreisen L1, L2, L3 mit einer Stromamplitude von beispielsweise 25 A. Die Anschlüsse für die Lasten 2-i und die Schnittstellen 21, 22 weisen vorzugsweise Steckverbindungen auf.

Die erfindungsgemäße Schaltvorrichtung 1 erlaubt eine Trennung des Überlastschutzes und des Kurzschlussschutzes. Der Kurzschlussschutz erfolgt mithilfe der Schmelzsicherungen 10, 11, 12, die vorzugsweise in einem Teillastbereich betrieben werden. Der Überlastschutz erfolgt durch Abschaltung mit betriebsmäßiger Schaltfunktion, beispielsweise bei Überschreiten von Schwellenwerten. Bei einer möglichen Ausführungsform kann die erfindungsgemäße Schaltvorrichtung 1 durch eine zentrale externe Steuerung automatisch betrieben werden. Alternativ kann die Schaltvorrichtung 1 auch auf Handsteuerung umgeschaltet werden. Bei einer weiteren möglichen Ausführungsform kann die lokale Steuerung 18 über eine Schnittstelle zunächst eine Warnmeldung bei einer Auffälligkeit der Stromversorgung abgeben und bei Auftreten eines Störfalls eine Störmeldung erzeugen.

Bei einer weiteren möglichen Ausführungsform der erfindungsgemäßen Schaltvorrichtung 1 erfolgt bei Ausfall eines Halbleiterschalters 7B, 8B, 9B der Schalteinheiten 7, 8, 9 zunächst ein zeitlich begrenzter Notbetrieb.

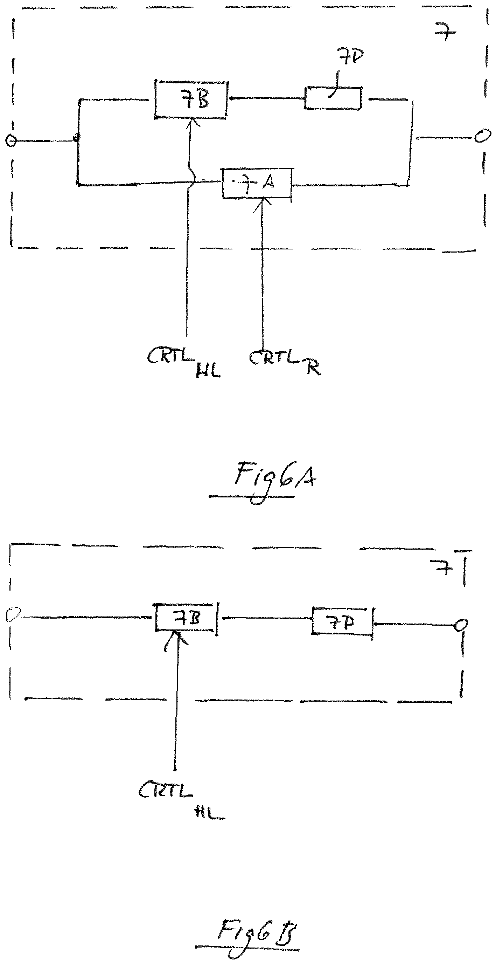

Die Figuren 6A, 6B zeigen Schaltungsdiagramme für Ausführungsvarianten einer in der erfindungsgemäßen Schaltvorrichtung 1 enthaltenen Schalteinheit. Figuren 6A, 6B zeigen Varianten der Schalteinheit 7, wie sie in der Schaltvorrichtung 1 gemäß Figuren 1A, 1B enthalten sind. Die beiden übrigen Schalteinheiten 8, 9 sind entsprechend aufgebaut. Die Schalteinheiten 7 weisen bei der in Fig. 6A dargestellten Ausführungsvariante jeweils einen mechanischen Schalter 7A und einen dazu parallel verschalteten Halbleiterschalter 7B auf. Der mechanische Schalter 7A kann beispielsweise durch ein Relais gebildet sein. Wie man aus Fig. 6A erkennen kann, sind der Halbleiterschalter 7B und der mechanische Schalter 7A in zwei parallelen Strompfaden geschaltet und können durch die lokale Steuereinheit 18 separat über zugehörige Steuersignale CRTL-HL und CRTL-R separat angesteuert werden. Bei der in Fig. 6A dargestellten Ausführungsform ist in dem Strompfad des Halbleiterschalters 7B, der beispielsweise durch einen Triac-Schalter gebildet wird, eine zusätzliche Schmelzsicherung 7D vorgesehen, die einen Notlaufbetrieb der an die Schaltvorrichtung 1 angeschlossenen Last ermöglicht. Die Schmelzeinheit 7D brennt beispielsweise bei einer Stromamplitude von mehr als 5 Ampere durch. Falls beispielsweise der Halbleiterschalter 7B bzw. der Triac durchlegiert und dann ständig einen Strom führt, brennt die dazu seriell verschaltete Schmelzsicherung 7D durch, sodass nunmehr nur noch ein Strom über das Schaltrelais 7A der angeschlossenen Last zugeführt wird. Bei beispielsweise 20.000 Schaltungen pro Tag können auf diese Weise noch beispielsweise tausende Schaltungsvorgänge durchgeführt werden, die einen fortgesetzten Notbetrieb von mehreren Wochen zulassen. Bei einer möglichen Ausführungsform erkennt die Überwachungseinheit 20 durch entsprechende Strommessungen in den beiden parallelen Strompfaden, dass nach Durchbrennen der Schmelzsicherung 7D in dem ersten Strompfad kein Strom mehr fließt, während über das Relais 7A weiterhin die Stromphase L zu der angeschlossenen Last geschaltet wird. In diesem Fall kann die lokale Steuerung 18 einen Notstrom bzw. Notbetrieb für die betroffene Schalteinheit 7 bzw. die daran angeschlossene Stromphase L1, beispielsweise über eine Nutzerschnittstelle, anzeigen. Schmelzen die entsprechenden Schmelzsicherungen 8D, 9D an den beiden übrigen Schalteinheiten 8, 9 durch, kann ein entsprechender Notlaufbetrieb auch für die beiden übrigen Stromphasen L2, L3 angezeigt werden.

Die Strommesseinheit 7C ist in dem Schaltungsdiagramm gemäß Fig. 6A nicht dargestellt. Die Strommesseinheit 7C kann dabei Ströme an einem oder beiden parallelen Strompfaden der Schalteinheit 7 sensorisch erfassen, beispielsweise durch GMR-Sensoren, die in einem oder beiden Strompfaden verschaltet sind.

Fig. 6B zeigt eine alternative Ausführungsvariante der Schalteinheit 7, bei der diese lediglich einen Halbleiterschalter 7B aufweist. Die übrigen Schalteinheiten 8, 9 können bei der in Fig. 1B dargestellten Ausführungsvariante analog aufgebaut sein. In Reihe zu dem Halbleiterschalter 7B ist eine Schmelzsicherung 7D vorgesehen, die beispielsweise durchbrennt, wenn der Halbleiterschalter 7B durchlegiert ist. Hierdurch wird die Stromversorgung für die an die Schalteinheit 7 angeschlossene Last 2-1 unterbrochen. Bei einer möglichen Ausführungsform wird die Unterbrechung der Stromversorgung für die Last 2-1 der Fehlerüberwachungseinheit 20 durch eine Strommesseinheit bzw. Stromsensor angezeigt, der in dem Strompfad der Schalteinheit 7 verschaltet ist. Der Ausfall der Stromversorgung für die an die Phase L1 angeschlossene Last 2-1 kann bei einer möglichen Ausführungsform durch die lokale Steuereinheit 18 über eine Nutzerschnittstelle angezeigt werden.

Die Überwachungseinheit 20 kann weitere Betriebsabweichungen von einer normalen Stromversorgung der an die Schalteinheiten 7, 8, 9 angeschlossenen Lasten erkennen. Beispielsweise kann die Überwachungseinheit 20 einen Phasenausfall der Phase L3 erkennen. Bei einer möglichen Ausführungsform misst die Überwachungseinheit 20 anschließend, wie lange der Phasenausfall der Stromversorgungsphase dauert. Dauert der entsprechende Phasenausfall nur wenige Sekunden, stellt dies lediglich eine Auffälligkeit dar, welche von der lokalen Steuereinheit 18 über eine Schnittstelle als Auffälligkeit gemeldet wird. Dauert der Phasenausfall allerdings längere Zeit an, beispielsweise mehr als 10 Sekunden, kann dies seitens der lokalen Steuereinheit 18 als Störfall betrachtet werden. Dieser Störfall wird durch die lokale Steuereinheit 18 über eine Nutzerschnittstelle angezeigt und der externen Steuerung 24 als Störfall gemeldet. Bei dieser Ausführungsvariante verfügt die Überwachungseinheit 20 über eine Zeitmesseinheit bzw. einen Zähler, mit dessen Hilfe die Dauer eines sensorisch erfassten Phasenausfalls gemessen wird.

Ein weiteres Beispiel für eine von der Überwachungseinheit 20 erkannte Betriebsabweichung ist ein weiterhin stattfindender Stromfluss, obwohl die zugehörige Last 2-i mithilfe eines Steuersignals abgeschaltet worden ist. Wird beispielsweise die Last 2-2 abgeschaltet und wird mithilfe der Strommesseinheit 8C festgestellt, dass trotzdem Strom über den Stromanschluss 14 zu der abgeschalteten Last 2-2 fließt, kann dies zunächst für wenige Sekunden als Auffälligkeit seitens der internen Steuerung 18 bewertet werden, sodass eine entsprechende Warnmeldung erzeugt wird. Fließt der Strom trotz Abschaltens der zugehörigen Last für einen längeren Zeitraum, beispielsweise für mehr als 20 Sekunden, kann dies seitens der internen Steuerung 18 als Störfall betrachtet werden, der eine entsprechende Störmeldung auslöst, welche beispielsweise an die externe Steuerung 24 übertragen wird. Bei einer bevorzugten Ausführungsform wird die Störmeldung auch über eine Nutzerschnittstelle der Schaltvorrichtung 1 einem Nutzer angezeigt. Die angezeigte oder übertragene Störmeldung gibt die Art des Störfalles an. Beispielsweise gibt die Störmeldung an, dass trotz abgeschalteter Last weiterhin Strom zu der entsprechenden Last über die zugehörige Schalteinheit fließt. Ein weiteres Beispiel für eine derartige Störmeldung ist, dass an einer bestimmten Phase, beispielsweise der Phase L3, ein länger andauernder Phasenausfall festgestellt wurde. Ein weiteres Beispiel für eine Störmeldung ist, dass die in einer Schalteinheit enthaltene Schmelzsicherung (Schmelzsicherung 7D) durchgebrannt ist und somit vermutlich der entsprechende Halbleiterschalter 7B durchlegiert ist. Die Störmeldungen enthalten somit bei einer möglichen Ausführungsform neben der Art der aufgetretenen Störung auch Informationen für den möglichen Grund der aufgetretenen Störung. Weiterhin können über die Anzeigeeinheit einem Nutzer Handlungsanweisungen zur Behebung der vermutlich aufgetretenen Störung angezeigt werden. Bei einer möglichen Ausführungsvariante werden die von der Überwachungseinheit 20 erkannten Betriebsauffälligkeiten und/oder Störfälle aufgezeichnet und ggf. an die externe Steuerung 24 zur Auswertung des Störfalles übertragen.

Bei einer möglichen Ausführungsform der erfindungsgemäßen Schaltvorrichtung 1 sind die in den Figuren 1A, 1B dargestellten Einheiten bzw. Komponenten der Schaltvorrichtung 1 auf einer Schaltplatine integriert. Die stromführenden Leitungen werden dabei vorzugsweise durch auf der Platine aufgebrachte Kupferbahnen gebildet. Bei einer möglichen Ausführungsform erfolgt die Messung eines Stromes I, welcher in den Kupferbahnen bzw. Leitungen fließt, durch die Messeinheiten 7C, 8C, 9C. Diese werden bei einer möglichen Ausführungsform durch GMR-Sensoren gebildet. Diese GMR-Sensoren können vorzugsweise zur Isolation auf der gegenüberliegenden bzw. rückliegenden Seite der Platine vorgesehen sein.

Bei einer möglichen Ausführungsform weist das Gehäuse 16 der Schaltvorrichtung 1 Lüftungsschlitze auf. Bei einer weiteren möglichen Ausführungsform der erfindungsgemäßen Schaltvorrichtung 1 ist an der Gehäuseaußenwand des Gehäuses 16 der Schaltvorrichtung 1 mindestens ein Lüftungskanal vorgesehen. Bei einer möglichen Ausführungsform kann die erfindungsgemäße Schaltvorrichtung 1 Standby-betrieben werden. Die erfindungsgemäße Schaltvorrichtung 1 erlaubt eine kaskadierte Schaltung mehrerer Geräte. Die Schaltvorrichtung 1 stellt ein elektronisches Schaltgerät mit hoher Nutzleistung, geringer Verlustleistung und hoher Anzahl von elektrischen Schaltspielen bereit. Die erfindungsgemäße Schaltvorrichtung 1 kann einfach an ein Schienensystem, insbesondere an ein Stromsammelschienensystem, montiert werden. Weiterhin bietet die erfindungsgemäße Schaltvorrichtung 1 sowohl einen Überlastschutz als auch einen Kurzschlussschutz.

Bei einer möglichen Ausführungsform weist die erfindungsgemäße Schaltvorrichtung 1 zusätzlich einen Konfigurationsspeicher auf. In diesem Konfigurationsspeicher können über eine Schnittstelle bestimmte Betriebsparameter konfiguriert werden. Diese Betriebsparameter umfassen beispielsweise Stromverläufe für eine normale Stromversorgung der an die Schaltvorrichtung 1 angeschlossenen Lasten 2-i. Beispielsweise können eine vorgegebene Amplitude und Frequenz sowie ein Signalverlauf der angeschlossenen Stromphase in dem Konfigurationsspeicher der Schaltvorrichtung 1 eingeschrieben werden. Beispielsweise ist in dem Konfigurationsspeicher eine Amplitude von 240 V bei einer Frequenz von 50 Hz und einem sinusförmigen Spannungsverlauf eingeschrieben bzw. gespeichert. Alternativ können auch andere Amplituden, Frequenzen oder auch Spannungsverläufe in dem Konfigurationsspeicher der Schaltvorrichtung 1 abgelegt werden. Die Überwachungseinheit 20 hat vorzugsweise Zugriff auf den Konfigurationsspeicher. Die Überwachungseinheit 20 vergleicht bei einer möglichen Ausführungsform den durch die Messeinheiten 7C, 8C, 9C gemessenen Stromphasenverlauf L(t), welcher an die Lasten 2-i abgegeben wird, mit dem im Konfigurationsspeicher gespeicherten Soll-Stromversorgungsverlauf. Bei einer Abweichung kann diese durch die Überwachungseinheit 20 der internen lokalen Steuerung 18 der Schaltvorrichtung 1 und/oder der externen Steuerung 24 der Anlage gemeldet werden.

## Patentansprüche

1. Schaltvorrichtung (1) zum Betreiben von mindestens einer Last mit:
mindestens einer Schalteinheit (7; 8; 9), die eine abgegriffene Stromphase (L) an eine an die Schalteinheit (7; 8; 9) anschließbare Last (2-1; 2-2; 2-3) zu deren Stromversorgung schaltet und eine Messeinheit (7C; 8C; 9C) aufweist, die einen Stromphasenverlauf der mindestens einen Stromphase (L) misst;
einer lokalen Steuereinheit (18), die nach Erhalt eines Steuerbefehls von einer externen Steuerung (24) einen Halbleiterschalter (7B; 8B; 9B) der Schalteinheit (7; 8; 9) derart ansteuert, dass der Halbleiterschalter (7B; 8B; 9B) bei einem Nulldurchgang der durch die Messeinheit (7C; 8C; 9C) gemessenen Stromphase (L) schaltet,
**dadurch gekennzeichnet, dass**
die Schaltvorrichtung (1) eine lokale Überwachungseinheit (20) aufweist, die den durch die Messeinheit (7C; 8C; 9C) gemessenen Stromphasenverlauf der mindestens einen Stromphase (L) zur Erkennung einer Betriebsabweichung von einer normalen Stromversorgung der jeweiligen an die Schalteinheit (7; 8; 9) angeschlossenen Last (2-1; 2-2; 2-3) auswertet und eine erkannte Betriebsabweichung meldet.

2. Schaltvorrichtung nach Anspruch 1,
wobei die mindestens eine Schalteinheit (7; 8; 9) durch eine Hybridschaltung gebildet wird,
wobei die Hybridschaltung einen mechanischen Schalter (7A; 8A; 9A) und einen dazu parallel verschalteten Halbleiterschalter (7B; 8B; 9B) aufweist.

3. Schaltvorrichtung nach Anspruch 1 oder 2,
wobei die Schaltvorrichtung (1) mindestens eine Strommesseinheit (7C; 8C; 9C; 19) aufweist, welche den zeitlichen Verlauf mindestens einer abgegriffenen Stromphase (L) überwacht.

4. Schaltvorrichtung nach Anspruch 3,
wobei die Strommesseinheit (7C; 8C; 9C; 19) einen Nulldurchgang der abgegriffenen Stromphase (L) erkennt und an die lokale Steuerung (18) der Schaltvorrichtung (1) meldet.

5. Schaltvorrichtung nach einem der vorangehenden Ansprüche 1 bis 4,
wobei die lokale Überwachungseinheit (20) überwacht, ob das Abgeben der abgegriffenen Stromphase (L) durch die Schalteinheit (7; 8; 9) entsprechend dem von der lokalen Steuerung (18) von einer externen Steuerung (24) erhaltenen Steuerbefehl erfolgt ist.

6. Schaltvorrichtung nach einem der vorangehenden Ansprüche 1 bis 5,
wobei die lokale Überwachungseinheit (20) einen aufgetretenen Schaltfehler erkennt und an die lokale Steuerung (18) der Schaltvorrichtung (1) meldet,
wobei die lokale Steuerung (18) der Schaltvorrichtung (1) einen ihr gemeldeten Schaltfehler über eine Schnittstelle (21) an eine externe Steuerung (24) weiterleitet.

7. Schaltvorrichtung nach einem der vorangehenden Ansprüche 1 bis 6,
wobei die abgegriffene Stromphase (L) der Schalteinheit (7; 8; 9) über eine austauschbare Schmelzsicherung (10; 11; 12) zugeleitet ist.

8. Schaltvorrichtung nach einem der vorangehenden Ansprüche 1 bis 7,
wobei die Überwachungseinheit (20) bei Auftreten eines Schaltfehlers die Art des aufgetretenen Schaltfehlers erkennt und die Art des aufgetretenen Schaltfehlers an die lokale Steuerung (18) der Schaltvorrichtung (1) meldet.

9. Schaltvorrichtung nach Anspruch 8,
wobei die Überwachungseinheit (20) erkennt, ob der aufgetretene Schaltfehler die Ursache für einen Ausfall einer abgegriffenen Stromphase (L) oder einen von der Schalteinheit (7; 8; 9) abgegebenen Dauerstrom umfasst.

10. Schaltvorrichtung nach Anspruch 9,
wobei die lokale Steuerung (18) die gemeldete Art des aufgetretenen Schaltfehlers über eine Schnittstelle (21) an die externe Steuerung (24) weiterleitet,
wobei die externe Steuerung (24) die von der lokalen Steuerung (18) der Schaltvorrichtung (1) gemeldeten Schaltfehler und/oder deren Art auswertet und die an die Schaltvorrichtung (1) angeschlossenen Lasten (2-i) entsprechend dem Auswertungsergebnis ansteuert.

11. Schaltvorrichtung nach einem der vorangehenden Ansprüche 1 bis 10,
wobei die Schaltvorrichtung (1) mindestens einen Temperatursensor aufweist, welcher eine interne Temperatur, insbesondere eine Temperatur der mindestens einen Schalteinheit (7; 8; 9) innerhalb der Schaltvorrichtung (1) überwacht und der lokalen Steuerung (18) der Schaltvorrichtung (1) meldet.

12. Schaltvorrichtung nach einem der vorangehenden Ansprüche 6 bis 11,
wobei die Schnittstellen (21; 22) der Schaltvorrichtung (1) über mindestens einen Optokoppler an die externe Steuerung (24) angeschlossen sind.

13. Schaltvorrichtung nach einem der vorangehenden Ansprüche 2 bis 12,
wobei der mechanische Schalter (7A; 8A; 9A) einer als Hybridschaltung ausgebildeten Schalteinheit (7; 8; 9) ein Relais aufweist,
wobei der Halbleiterschalter (7B; 8B; 9B) der als Hybridschaltung ausgebildeten Schalteinheit (7; 8; 9) ein Triac aufweist.

14. Schaltvorrichtung nach einem der vorangehenden Ansprüche 2 bis 13,
wobei die Schaltvorrichtung (1) drei als Hybridschaltungen ausgebildete Schalteinheiten (7; 8; 9) für drei abgegriffene Stromphasen (L1; L2; L3) aufweist, die jeweils ein mechanisches Relais und einen dazu parallel verschalteten Triac aufweisen.

15. Schaltvorrichtung nach einem der vorangehenden Ansprüche 1 bis 14,
wobei die gesamte Schaltvorrichtung (1) in einem Gerätegehäuse (16) integriert ist oder jeweils eine Schalteinheit (7; 8; 9) und eine zugehörige lokale Steuerung in einem separaten Gerätegehäuse integriert sind,
wobei das Gerätegehäuse der Schaltvorrichtung (1) für jede Stromphase (L) eine zugehörige Schienenkontaktierung aufweist.

16. Schaltvorrichtung nach einem der vorangehenden Ansprüche 1 bis 15,
wobei eine externe Steuerung (24) über eine Steckverbindung an die mindestens eine lokale Steuerung (18) der Schaltvorrichtung (1) anschließbar ist,
wobei die mindestens eine Last (2) über eine Steckverbindung an eine Schalteinheit (7; 8; 9) der Schaltvorrichtung (1) anschließbar ist.

17. Schaltvorrichtung nach einem der vorangehenden Ansprüche 1 bis 16,
wobei die Schaltvorrichtung (1) zu einem Stromnetz synchronisiert ist.

18. Schaltvorrichtung nach einem der vorangehenden Ansprüche 3 bis 17,
wobei die Strommesseinheit (7C; 8C; 9C; 19) einen GMR-Sensor, eine Rogowski-Spule, einen Stromwandler, einen Hallsensor oder einen Shuntmesswiderstand aufweist.

19. Schaltvorrichtung nach einem der vorangehenden Ansprüche 1 bis 18, wobei die Schaltvorrichtung (1) auf einer Hutschiene oder Montageplatte montierbar ist.

20. Schaltvorrichtung nach einem der vorangehenden Ansprüche 1 bis 19, wobei die Schaltvorrichtung (1) mindestens eine Wendestufe (25) aufweist.

21. Schienensystem (3) mit mehreren Schienen (3-1; 3-2; 3-3) für Stromphasen (L1; L2; L3) und mit mindestens einer Schaltvorrichtung (1) nach einem der vorangehenden Ansprüche 1 bis 18, die mittels Schienenkontaktierungen an die Schienen (3-1; 3-2; 3-3) zum Abgriff der Stromphasen (L1; L2; L3) angeschlossen ist, wobei an jede Schalteinheit (7; 8; 9) der Schaltvorrichtung (1) eine Last (2-1; 2-2; 2-3) anschließbar ist.

22. Schienensystem nach Anspruch 21,
wobei das Schienensystem (3) ein Stromsammelschienensystem mit mehreren parallel angeordneten Stromsammelschienen aufweist .

## Claims

1. Switching device (1) for operating at least one load, comprising:
at least one switching unit (7; 8; 9), which switches a tapped current phase (L) towards a load (2-1; 2-2; 2-3), which is connectable to the switching unit (7; 8; 9), so as to supply said load with power, and has a measurement unit (7C; 8C; 9C) which measures a current phase progression of the at least one current phase (L);
a local control unit (18), which after receiving a control command from an external control system (24) actuates a semiconductor switch (7B; 8B; 9B) of the switching unit (7; 8; 9) in such a way that the semiconductor switch (7B; 8B; 9B) switches at a zero point of the current phase (L) measured by the measurement unit (7C; 8C; 9C),
**characterised in that**
the switching device (1) has a local monitoring unit (20), which evaluates the current phase progression, measured by the measurement unit (7C; 8C; 9C), of the at least one current phase (L) so as to detect an operating deviation from a normal power supply of the associated load (2-1; 2-2; 2-3) connected to the switching unit (7; 8; 9) and reports a detected operating deviation.

2. Switching device according to claim 1,
wherein the at least one switching unit (7; 8; 9) is formed by a hybrid circuit,
wherein the hybrid circuit has a mechanical switch (7A; 8A; 9A) and a semiconductor switch (7B; 8B; 9B) connected in parallel therewith.

3. Switching device according to either claim 1 or claim 2,
wherein the switching device (1) has at least one current measurement unit (7C; 8C; 9C; 19) which monitors the progression over time of at least one tapped current phase (L) .

4. Switching device according to claim 3,
wherein the current measurement unit (7C; 8C; 9C; 19) detects a zero point of the tapped current phase (L) and reports it to the local control system (18) of the switching device (1).

5. Switching device according to any of preceding claims 1 to 4,
wherein the local unit (20) monitors whether the tapped current phase (L) has been outputted by the switching unit (7; 8; 9) in accordance with the control command received by the local control system (18) from an external control system (24).

6. Switching device according to any of preceding claims 1 to 5,
wherein the local monitoring unit (20) detects a switching error which has occurred and reports it to the local control system (18) of the switching device (1),
wherein the local control system (18) of the switching device (1) passes on a switching error reported thereto to an external control system (24) via an interface (21).

7. Switching device according to any of preceding claims 1 to 6,
wherein the tapped current phase (L) is fed to the switching unit (7; 8; 9) via a replaceable fuse (10; 11; 12).

8. Switching device according to any of preceding claims 1 to 7,
wherein the monitoring unit (20), when a switching error occurs, detects the type of the switching error which has occurred and reports the type of the switching error which has occurred to the local control system (18) of the switching device (1).

9. Switching device according to claim 8,
wherein the monitoring unit (20) detects whether the switching error which has occurred is the cause of a failure of a tapped current phase (L) or of a constant current outputted by the current unit (7; 8; 9).

10. Switching device according to claim 9,
wherein the local control system (18) passes on the reported type of the switching error which has occurred to the external control system (24) via an interface (21),
wherein the external control system (24) evaluates the switching error reported by the local control system (18) of the switching device (1) and/or the type of said error and actuates the loads (2-i) connected to the switching device (1) in accordance with the evaluation result.

11. Switching device according to any of preceding claims 1 to 10,
wherein the switching device (1) has at least one temperature sensor, which monitors an internal temperature, in particular a temperature of the at least one switching unit (7; 8; 9) within the switching device (1), and reports it to the local control system (18) of the switching device (1) .

12. Switching device according to any of preceding claims 6 to 11,
wherein the interfaces (21; 22) of the switching device (1) are connected to the external control system (24) via at least one optical coupler.

13. Switching device according to any of preceding claims 2 to 12,
wherein the mechanical switch (7A; 8A; 9A) of a switching unit (7; 8; 9) formed as a hybrid switch has a relay,
wherein the semiconductor switch (7B; 8B; 9B) of the switching unit (7; 8; 9) formed as a hybrid switch has a TRIAC.

14. Switching device according to any of preceding claims 2 to 13,
wherein the switching device (1) has three switching units (7; 8; 9), formed as hybrid circuits, for three tapped current phases (L1; L2; L3), which each have a mechanical relay and a TRIAC connected in parallel therewith.

15. Switching device according to any of preceding claims 1 to 14,
wherein the entire switching device (1) is integrated into an appliance housing (16) or a switching unit (7; 8; 9) and an associated local control system are integrated into a separate appliance housing in each case,
wherein the appliance housing of the switching device (1) has an associated rail contact for each current phase (L).

16. Switching device according to any of preceding claims 1 to 15,
wherein an external control system (24) is connectable via a plug-in connection to the at least one local control system (18) of the switching device (1),
wherein the at least one load (2) is connectable via a plug-in connection to a switching unit (7; 8; 9) of the switching device (1).

17. Switching device according to any of preceding claims 1 to 16,
wherein the switching device (1) is synchronised with a power network.

18. Switching device according to any of preceding claims 3 to 17,
wherein the current measurement unit (7C; 8C; 9C; 19) has a GMR sensor, a Rogowski coil, a transformer, a Hall sensor or a shunt measuring resistor.

19. Switching device according to any of preceding claims 1 to 18, wherein the switching device (1) can be mounted on a top-hat rail or mounting plate.

20. Switching device according to any of preceding claims 1 to 19, wherein the switching device (1) has at least one reversing stage (25).

21. Rail system (3) comprising a plurality of rails (3-1; 3-2; 3-3) for current phases (L1; L2; L3) and comprising at least one switching device (1) according to any of preceding claims 1 to 18, which is connected to the rails (3-1; 3-2; 3-3) by means of rail contacting systems so as to tap the current phases (L1; L2; L3), a load (2-1; 2-2; 2-3) being connectable to each switching unit (7; 8; 9) of the switching device (1).

22. Rail system according to claim 21,
wherein the rail system (3) has a busbar system comprising a plurality of busbars arranged in parallel.

## Revendications

1. Dispositif de commutation (1) destiné à faire fonctionner au moins une charge, comportant :
au moins une unité de commutation (7 ; 8 ; 9), qui commute une phase de courant prélevée (L) sur une charge (2-1 ; 2-2 ; 2-3) qui peut être raccordée à l'unité de commutation (7 ; 8 ; 9) pour son alimentation en courant et présente une unité de mesure (7C ; 8C ; 9C) qui mesure une variation de phase de courant de l'au moins une phase de courant (L) ;
une unité de commande locale (18) qui, après réception d'une instruction de commande d'un dispositif de commande externe (24), pilote un commutateur à semi-conducteurs (7B ; 8B ; 9B) de l'unité de commutation (7 ; 8 ; 9) de telle sorte que le commutateur à semi-conducteurs (7B ; 8B ; 9B) est commuté lors d'un passage à zéro de la phase de courant (L) mesurée par l'unité de mesure (7C ; 8C ; 9C),
**caractérisé en ce que**
le dispositif de commutation (1) présente une unité de surveillance locale (20) qui évalue la variation de phase de courant de l'au moins une phase de courant (L) mesurée par l'unité de mesure (7C ; 8C ; 9C) pour détecter une anomalie de fonctionnement par rapport à une alimentation en courant normale de la charge (2-1 ; 2-2 ; 2-3) respective raccordée à l'unité de commutation (7 ; 8 ; 9) et signale une anomalie de fonctionnement détectée.

2. Dispositif de commutation selon la revendication 1,
dans lequel l'au moins une unité de commutation (7 ; 8 ; 9) est formée d'un circuit hybride,
dans lequel le circuit hybride présente un commutateur mécanique (7A ; 8A ; 9A) et un commutateur à semi-conducteurs (7B ; 8B ; 9B) connecté en parallèle à celui-ci.

3. Dispositif de commutation selon la revendication 1 ou 2,
dans lequel le dispositif de commutation (1) présente au moins une unité de mesure de courant (7C ; 8C ; 9C ; 19) qui surveille la variation dans le temps d'au moins une phase de courant prélevée (L).

4. Dispositif de commutation selon la revendication 3,
dans lequel l'unité de mesure de courant (7C ; 8C ; 9C ; 19) détecte un passage à zéro de la phase de courant prélevée (L) et le signale au dispositif de commande local (18) du dispositif de commutation (1).

5. Dispositif de commutation selon une des revendications précédentes 1 à 4,
dans lequel l'unité de surveillance locale (20) surveille si la transmission de la phase de courant prélevée (L) par l'unité de commutation (7 ; 8 ; 9) est effectuée conformément à l'instruction de commande reçue par le dispositif de commande local (18) d'un dispositif de commande externe (24).

6. Dispositif de commutation selon une des revendications précédentes 1 à 5,
dans lequel l'unité de surveillance locale (20) détecte la survenue d'une erreur de commutation et la signale au dispositif de commande local (18) du dispositif de commutation (1),
dans lequel le dispositif de commande local (18) du dispositif de commutation (1) transfère à un dispositif de commande externe (24) par le biais d'une interface (21) une erreur de commutation qui lui a été signalée.

7. Dispositif de commutation selon une des revendications précédentes 1 à 6,
dans lequel la phase de courant prélevée (L) de l'unité de commutation (7 ; 8 ; 9) est acheminée par le biais d'un coupe-circuit à fusible remplaçable (10 ; 11 ; 12).

8. Dispositif de commutation selon une des revendications précédentes 1 à 7,
dans lequel, lors de la survenue d'une erreur de commutation, l'unité de surveillance (20) détecte le type d'erreur de commutation qui est survenue et le signale au dispositif de commande local (18) du dispositif de commutation (1).

9. Dispositif de commutation selon la revendication 8,
dans lequel l'unité de surveillance (20) détecte si l'erreur de commutation qui est survenue comprend la cause de défaillance d'une phase de courant prélevée (L) ou un courant permanent délivré par l'unité de commutation (7 ; 8 ; 9).

10. Dispositif de commutation selon la revendication 9,
dans lequel le dispositif de commande local (18) transfère au dispositif de commande externe (24) par le biais d'une interface (21) le type d'erreur de commutation survenue qui a été signalé,
dans lequel le dispositif de commande externe (24) évalue les erreurs de commutation signalées par le dispositif de commande local (18) du dispositif de commutation (1) et/ou le type de celles-ci et pilote les charges (2-i) raccordées au dispositif de commutation (1) en fonction du résultat de l'évaluation.

11. Dispositif de commutation selon une des revendications précédentes 1 à 10,
dans lequel le dispositif de commutation (1) présente au moins un capteur de température qui surveille une température interne, en particulier une température de l'au moins une unité de commutation (7 ; 8 ; 9) à l'intérieur du dispositif de commutation (1) et la signale au dispositif de commande local (18) du dispositif de commutation (1).

12. Dispositif de commutation selon une des revendications précédentes 6 à 11,
dans lequel les interfaces (21 ; 22) du dispositif de commutation (1) sont raccordées au dispositif de commande externe (24) par le biais d'au moins un photocoupleur.

13. Dispositif de commutation selon une des revendications précédentes 2 à 12,
dans lequel le commutateur mécanique (7A ; 8A ; 9A) d'une unité de commutation (7 ; 8 ; 9) réalisée sous la forme d'un circuit hybride présente un relais,
dans lequel le commutateur à semi-conducteurs (7B ; 8B ; 9B) de l'unité de commutation (7 ; 8 ; 9) réalisée sous la forme d'un circuit hybride présente un triac.

14. Dispositif de commutation selon une des revendications précédentes 2 à 13,
dans lequel le dispositif de commutation (1) présente trois unités de commutations (7 ; 8 ; 9) réalisées sous la forme de circuits hybrides pour trois phases de courant prélevées (L1 ; L2 ; L3) qui présentent respectivement un relais mécanique et un triac connecté en parallèle à celui-ci.

15. Dispositif de commutation selon une des revendications précédentes 1 à 14,
dans lequel l'ensemble du dispositif de commutation (1) est intégré dans un boîtier d'appareil (16) ou respectivement une unité de commutation (7 ; 8 ; 9) et un dispositif de commande local correspondant sont intégrés dans un boîtier d'appareil séparé,
dans lequel le boîtier d'appareil du dispositif de commutation (1) présente pour chaque phase de courant (L) une mise en contact de rail correspondante.

16. Dispositif de commutation selon une des revendications précédentes 1 à 15,
dans lequel un dispositif de commande externe (24) peut être raccordé par le biais d'un connecteur à l'au moins un dispositif de commande local (18) du dispositif de commutation (1),
dans lequel l'au moins une charge (2) peut être raccordée par le biais d'un connecteur à une unité de commutation (7 ; 8 ; 9) du dispositif de commutation (1).

17. Dispositif de commutation selon une des revendications précédentes 1 à 16,
dans lequel le dispositif de commutation (1) est synchronisé sur un réseau de distribution électrique.

18. Dispositif de commutation selon une des revendications précédentes 3 à 17,
dans lequel l'unité de mesure de courant (7C ; 8C ; 9C ; 19) présente un capteur GMR, une bobine de Rogowski, un transformateur de courant, un capteur à effet Hall ou une résistance de mesure shunt.

19. Dispositif de commutation selon une des revendications précédentes 1 à 18, dans lequel le dispositif de commutation (1) peut être monté sur un profilé chapeau ou une plaque de montage.

20. Dispositif de commutation selon une des revendications précédentes 1 à 19, dans lequel le dispositif de commutation (1) présente au moins un étage de retournement (25).

21. Système de rails (3) comportant plusieurs rails (3-1 ; 3-2 ; 3-3) pour des phases de courant (L1 ; L2 ; L3) et comportant au moins un dispositif de commutation (1) selon une des revendications précédentes 1 à 18 qui est raccordé aux rails (3-1 ; 3-2 ; 3-3) à l'aide de mises en contact de rails pour prélever les phases de courant (L1 ; L2 ; L3), dans lequel une charge (2-1 ; 2-2 ; 2-3) peut être raccordée à chaque unité de commutation (7 ; 8 ; 9) du dispositif de commutation (1).

22. Système de rail selon la revendication 21,
dans lequel le système de rail (3) présente un système de barres omnibus avec plusieurs barres omnibus disposées en parallèle.
